# EUROPEAN PATENT SPECIFICATION

(11) **EP 3 522 687 B1**
(45) Date of publication and mention of the grant of the patent: **19.07.2023**
(21) Application number: 16917757.3
(22) Date of filing: 30.09.2016
(51) Int. Cl.: H05K 3/34, B23K 1/00

(54) **MACHINE FOR PERFORMING WORK ON SUBSTRATE, AND INSERTION METHOD**
MASCHINE ZUR DURCHFÜHRUNG VON ARBEIT AUF EINEM SUBSTRAT UND EINFÜHRVERFAHREN
MACHINE DESTINÉE À EFFECTUER UN TRAVAIL SUR UN SUBSTRAT, ET PROCÉDÉ D'INSERTION

(43) Date of publication of application: 07.08.2019
(73) Proprietor: Fuji Corporation, Chiryu-shi, Aichi 472-8686 (JP)
(72) Inventor: IWAKI, Noriaki, Chiryu, Aichi, (JP)
(74) Representative: Grünecker Patent- und Rechtsanwälte PartG mbB
(86) International application number: PCT/JP2016/079142
(87) International publication number: WO 2018/061207

(56) References cited:
- WO-A1-2014/045370
- WO-A1-2016/056045
- JP-A- 2003 051 671
- JP-A- 2011 254 034
- JP-A- 2011 254 034
- JP-A- 2014 130 948
- JP-A- 2014 130 948

## Description

### Technical Field

The present invention relates to a board work machine that mounts a leaded component on a board, and to an insertion method for inserting a leaded component into a board.

### Background Art

A leaded component is mounted by the leads of the component being inserted into through-holes formed in a board and solder being applied to those leads. Disclosed in the WO2014/045370 and JP-A-2012-028712 is technology for applying molten solder to leads inserted into through-holes by flowing molten solder towards the leads so as to attach a leaded component to a board via solder.

WO 2016/056045 A1 discloses a board work machine according to the preamble of independent claim 1 and an insertion method according to the preamble of independent claim 3.

### Technical Problem

According to technology disclosed in the above patent literature, it is possible to attach a leaded component to a board via solder. However, when applying molten solder to the leads, there is a tendency for positional deviation of the leaded component to occur. Also, due to the surface tension that occurs as the molten solder hardens, there is a tendency for positional deviation of the leaded component to occur after application of molten solder has been completed as well as during application of molten solder. When positional deviation of a leaded component occurs in this manner, the mounting accuracy of the leaded component worsens, worsening the quality of the board. The present invention takes account of such circumstances and an object thereof is to improve the mounting accuracy of a leaded component.

### Summary of Invention

The object is achieved with a board work machine according to claim 1, and with an insertion method according to claim 3. A preferred embodiment is set out in the dependent claim.

### Advantageous Effects

The present invention improves the mounting accuracy of a leaded component.

### Brief Description of Drawings

Fig. 1

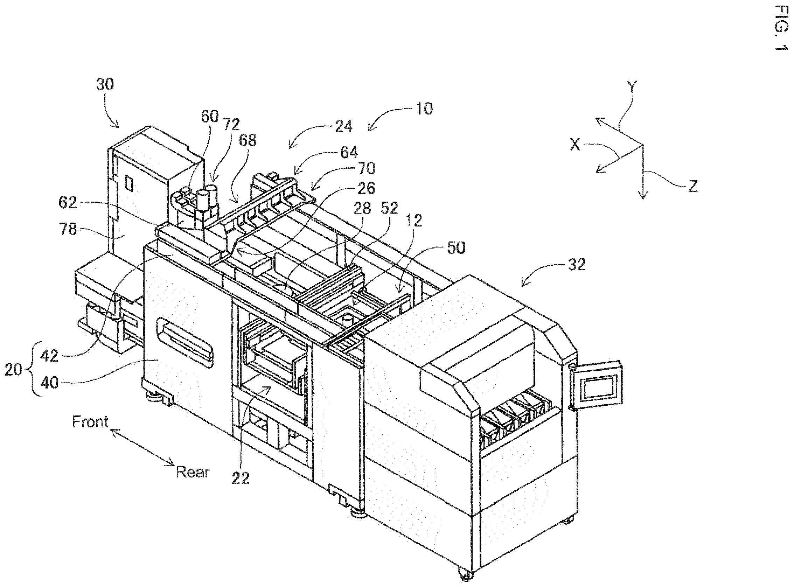

   Fig. 1 is a perspective view of a component mounter.
Fig. 2

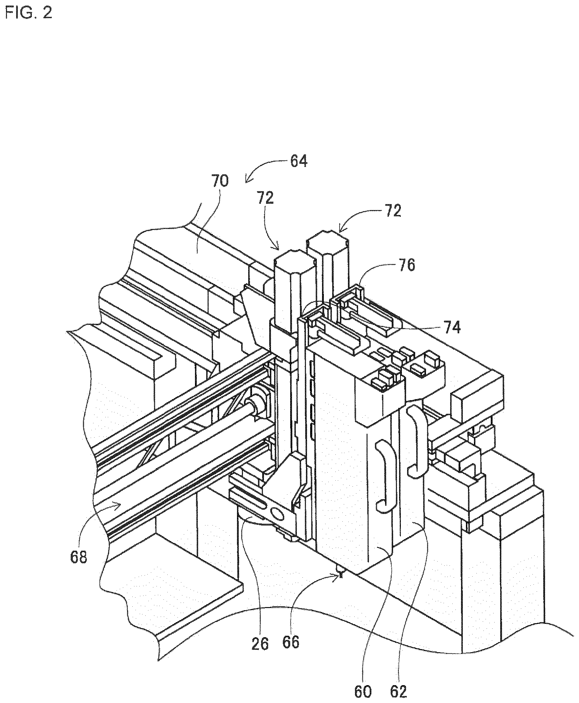

   Fig. 2 is a perspective view of a component mounting device.
Fig. 3

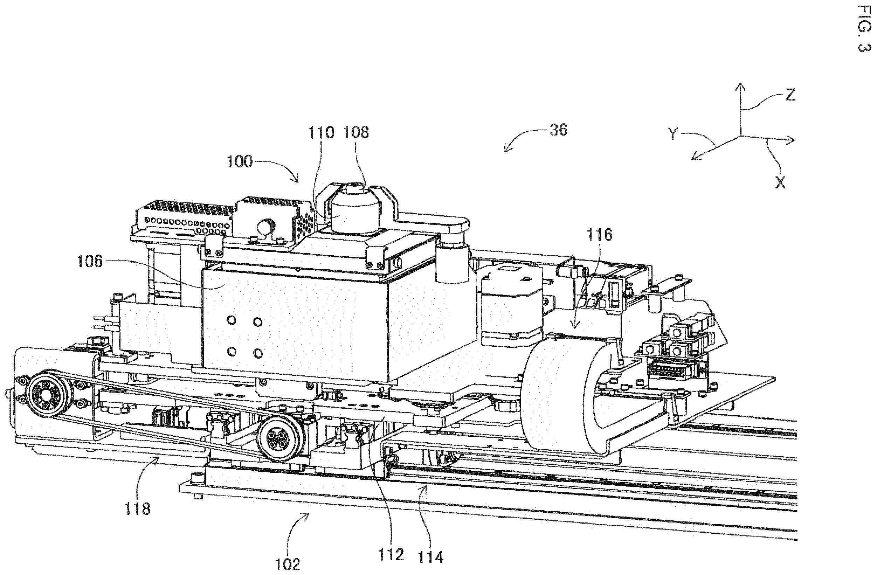

   Fig. 3 is a perspective view of a soldering device.
Fig. 4

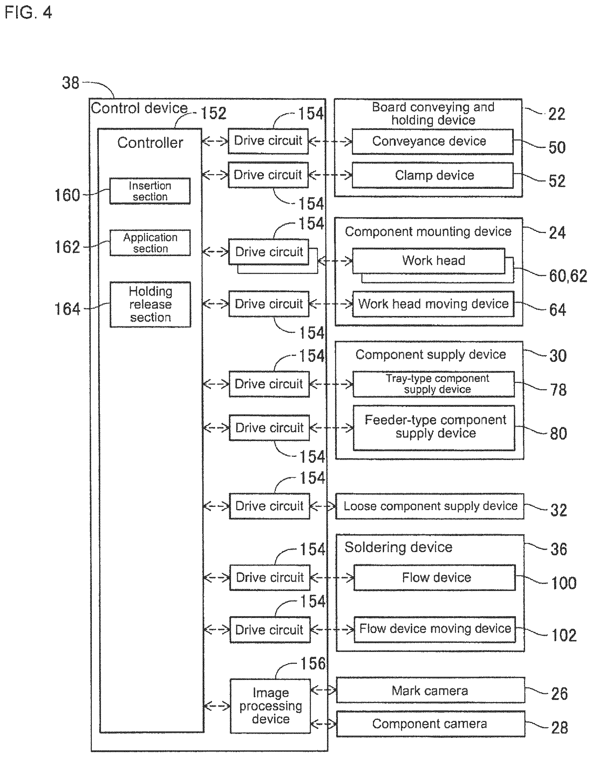

   Fig. 4 is a block diagram showing a control device.
Fig. 5

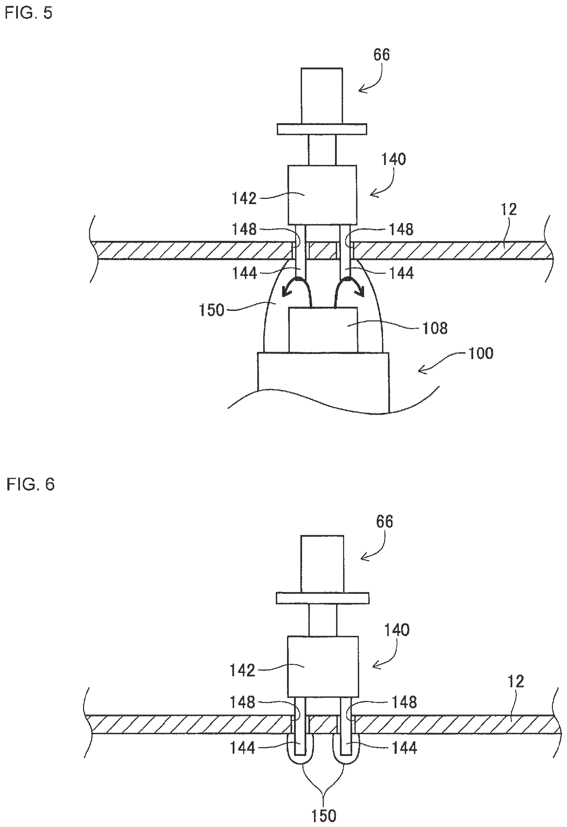

   Fig. 5 is a schematic view showing a state in which molten solder is being flowed towards a lead inserted into a through-hole of a circuit board.
Fig. 6
   Fig. 6 is a schematic view showing a state in which the leaded component is being held by a suction nozzle even after flowing of the molten solder onto the lead has been completed.

### Description of Preferred Embodiments

The following describes in detail referring to the figures an example embodiment of the present invention.

### Configuration of component mounter

Fig. 1 shows component mounter 10. Component mounter 10 performs work of mounting components on circuit board 12. Component mounter 10 is provided with device main body 20, board conveying and holding device 22, component mounting device 24, mark camera 26, component camera 28, component supply device 30, loose component supply device 32, soldering device (refer to fig. 3) 36, and control device (refer to fig. 4) 38. Note that, examples of circuit board 12 include circuit boards and boards with a three-dimensional construction, examples of a circuit board being a printed wiring board or a printed circuit board.

Device main body 20 is configured from frame section 40 and beam section 42 that is mounted on the frame section 40. Board conveying and holding device 22 is positioned centrally inside frame section 40 in the front-rear direction, and includes conveyance device 50 and clamp device 52. Conveyance device 50 conveys circuit board 12, and clamp device 52 holds circuit board 12. Thus, board conveying and holding device 22 conveys circuit board 12 and holds circuit board 12 at a specified position. Note that, in the descriptions below, the conveyance direction of circuit board 12 is referred to as the X direction, the direction horizontally perpendicular to the X direction is referred to as the Y direction, and the vertical direction is referred to as the Z direction. That is, the width direction of component mounter 10 is the X direction, and the front-rear direction is the Y direction.

Component mounting device 24 is provided on beam section 42, and includes work heads 60 and 62 and work head moving device 64. As shown in fig. 2, suction nozzle 66 is provided on a lower surface of each work head 60 and 62, with a component being picked up and held by the suction nozzle 66. Further, work head moving device 64 includes X-direction moving device 68, Y-direction moving device 70, and Z-direction moving device 72. Work heads 60 and 62 are moved together to any position on frame 40 by X-direction moving device 68 and Y-direction moving device 70. Also, work heads 60 and 62 are detachably attached to sliders 74 and 76 respectively, and Z-direction moving device 72 moves sliders 74 and 76 in a vertical direction individually. That is, work heads 60 and 62 are moved in a vertical direction individually by Z-direction moving device 72.

Mark camera 26 is attached to slide 74 in a state facing downwards, and is moved in the X direction, Y direction, and Z direction together with work head 60. Thus, mark camera 26 images any position on frame section 40. As shown in fig. 1, component camera 28 is provided in a state facing upwards on frame section 40 between board conveying and holding device 22 and component supply device 30. Thus, component camera 28 images a component held by suction nozzle 66 of work heads 60 or 62.

Component supply device 30 is provided at an end of frame section 40 in the front-rear direction. Component supply device 30 includes tray-type component supply device 78 and feeder-type component supply device (refer to fig. 4) 80. Tray-type component supply device 78 supplies components in a state arranged in a tray. Feeder-type component supply 80 device supplies components via a tape feeder or stick feeder (not shown).

Loose component supply device 32 is provided at the other end of frame section 40 in the front-rear direction. Loose component supply device 32 lines up multiple components that are in a scattered state, and supplies the components in a lined-up state. That is, this device arranges multiple components that have random orientations to have a specified orientation and supplies the components in the specified orientation. Note that, components supplied by component supply device 30 and loose component supply device 32 may include electronic circuit components, configuration components of power modules, and the like. Also, electronic circuit components include components with leads and components without leads.

Solder applying device 36 is arranged below conveyance device 50, and as shown in fig. 3, includes flow device 100 and flow device moving device 102. Flow device 100 includes solder pot 106, flow nozzle 108, and nozzle cover 110. Solder pot 106 is a roughly rectangular parallelepiped with molten solder stored inside. Flow nozzle 108 is provided at the upper surface of solder pot 106. By operation of a pump (not shown), molten solder is pumped up from solder pot 106, such that molten solder flows upwards from the upper tip of flow nozzle 108. Nozzle cover 110 is roughly cylindrical and is provided at the upper surface if solder pot 106 so as to surround flow nozzle 108. Thus, molten solder that flows from the upper end of flow nozzle 108 passes between the outer circumferential surface of flow nozzle 108 and the inner circumferential surface of nozzle cover 110, and is circulated inside solder pot 106.

Flow device moving device 102 includes slider 112, X-direction moving device 114, Y-direction moving device 116, and Z-direction moving device 118. Slider 112 is roughly plate-shaped and flow device 100 is provided on an upper surface of slider 112. Also, X-direction moving device 114 moves slider 112 in the conveyance direction of circuit board 12 by conveyance device 50, that is, the X direction; Y-direction moving device 116 moves slider 112 in the Y direction. Further, Z-direction moving device 118 moves slider 112 in the Z direction, that is, the vertical direction. By this, flow device 100 is moved to any position by operation of flow device moving device 102 under conveyance device 50.

Also, as shown in fig. 4, control device 38 is provided with controller 152, multiple drive circuits 154, and image processing device 156. The multiple drive circuits 154 are connected to conveyance device 50, clamp device 52, work heads 60 and 62, work head moving device 64, tray type component supply device 78, feeder type component supply device 80, loose component supply device 32, flow device 100, and flow device moving device 102. Controller 152 is formed mainly from a computer, provided with a CPU, ROM, RAM, and so on, and connected to the multiple drive circuits 156. By this, operation of board conveying and holding device 22, component mounting device 24, and so on is controlled by controller 152. Controller 152 is also connected to image processing device 156. Image processing device 156 is for processing image data acquired by mark camera 26 and component camera 28, and controller 152 acquires various information from the image data.

### Component mounter operation

Component mounter 10, according to the above configuration, mounts components on circuit board 12 held by board conveying and holding device 22. With component mounter 10, it is possible to mount various components to circuit board 12; descriptions are given below of a case in which components with leads (hereinafter also referred to as "leaded component") are mounted on circuit board 12.

Specifically, circuit board 12 is conveyed to a work position, and is held at that position by clamp device 52. Next, mark camera 26 moves above circuit board 12 and images circuit board 12. By this, information related to a holding position of circuit board 12 is obtained. Also, component supply device 30 or loose component supply device 32 supplies components at a specified supply position. One of the work heads 60 or 62 moves above the component supply position and holds a component using suction nozzle 66. Note that, as shown in fig. 5, leaded component 140 is configured from component main body section 142, and two leads 144 protruding from the bottom surface of component main body section 142. Leaded component 140 is picked up and held by a suction nozzle 66 on the surface opposite to the bottom surface of component main body section 142.

Continuing, work head 60 or 62 holding leaded component 140 is moved above component camera 28, and leaded component 140 held by suction nozzle 66 is imaged by component camera 28. Accordingly, information related to the holding position of the component is obtained. Continuing, work head 60 or 62 holding leaded component 140 moves above circuit board 12, and corrects the error in the holding position of circuit board 12 and the error in the holding position of the component and so on. Then, leads 144 of leaded component 140 held by suction nozzle 66 are inserted into through-holes formed in circuit board 12.

The insertion amount of leads 144 is set for each type of leaded component 140. Specifically, the insertion amount of lead 144 is set for each type of leaded component 140, for example, for a case in which leads 144 are to be inserted into through-holes 148 such that the bottom surface of component main body section 142 of leaded component 140 contacts the upper surface of circuit board 12, or for a case in which leads 144 are to be inserted into through-holes 148 such that a gap is maintained between the bottom surface of component main body section 142 of leaded component 140 and the upper surface of circuit board 12. Descriptions here are for a case in which leads 144 are inserted into through-holes 148 such that a gap is maintained between the bottom surface of component main body section 142 of leaded component 140 and the upper surface of circuit board 12, that is, for a case in which leads 144 are inserted into through-holes 148 such that component main body section 142 of leaded component 140 is held in a state away from circuit board 12.

Further, when leads 144 are inserted into through-holes 148 of circuit board 12, flow device 100 is moved below through-holes 148. Then, molten solder is flowed by flow device 100 towards leads 144 of leaded component 140 held by suction nozzle 66 such that molten solder is applied to leads 144. In detail, when leads 144 of leaded component 140 picked up and held by suction nozzle 66 are inserted into through-holes 148 formed in circuit board 12, flow device 100 positioned below through-holes 148 is moved up such that flow nozzle 108 of flow device 100 approaches the tip sections of leads 144 inserted into through-holes 148. The approaching speed of flow nozzle 108, that is, raising speed V1 (mm/sec) of flow device 100, is set in advance.

Note that, with flow device 100 positioned below through-hole 148, molten solder flows from the tip section of flow nozzle 108. Therefore, when flow device 100 is raised to a specified height, as shown in fig. 5, molten solder 150 flowing from the tip section of flow nozzle 108 is applied to the tip section of leads 144. In other words, molten solder 150 flows from flow nozzle 108 towards leads 144 of leaded component 140 being held by suction nozzle 66, such that molten solder 150 is applied to the tip sections of leads 144 and to the through-holes of circuit board 12. Note that, the raising of flow device 100 is stopped when flow device has been raised to a specified height, and flow device 100 is maintained at that height.

Also, application time T₁ (sec) for applying molten solder 150 to leads 144 from flow nozzle 108 is set in advance. Therefore, the elapsed time since starting application of molten solder 150 to leads 144 by flow nozzle 108, that is, the elapsed time since flow device 100 was raised to the specified height, is measured by a timer. Then, when the elapsed time has reached application time T₁ (sec), flow device 100 is lowered. Note that, when flow device 100 is lowered, molten solder 150 continues to flow from flow nozzle 108. Thus, flow nozzle 108 from which molten solder 150 is flowing is separated from leads 144, then application of molten solder 150 to leads 144 is stopped. Note that, the speed from which flow nozzle 108 separates from leads 144 when application of molten solder 150 is complete, that is, lowering speed V₂ (mm/sec) of flow device 100 is also set in advance.

Application time T₁ of molten solder 150, raising speed V₁ of flow device 100, and lowering speed V₂ of flow device 100 are set for each type of leaded component 140 to which molten solder is to be applied, specifically, in accordance with the size, shape, capacity, and heat dissipation ratio of leaded component 140, and the length, diameter, and the like of leads 144. By this, it is possible to apply an amount of molten solder to leads 144 in accordance with the type of leaded component 140.

Further, holding time T₂ (sec) is set in advance such that leaded component 140 is held by suction nozzle 66 even after application of molten solder 150 to leads 144 has been completed. Therefore, the elapsed time since completion of application of molten solder 150 to leads 144, that is, the elapsed time since flow device 100 was started to be lowered is measured by a timer. Then, when the elapsed time has reached holding time T₂ (sec), holding of leaded component 140 by suction nozzle 66 is released. That is, as shown in fig. 6, leaded component 140 is held by suction nozzle 66 for a specified time even after molten solder 150 has finished being applied to leads 144.

Note that, holding time T₂ (sec) is set as the time supposed to be required for the molten solder to harden after the completion of application of the molten solder 150 and is set in accordance with factors such as the type of the leaded component 140 to which the molten solder is being applied, specifically, at least one of the size, shape, thermal capacity, and heat dissipation ratio of leaded component 140 and the length and diameter of leads 144, the insertion amount of leads 144 into through-holes 148, the mounting orientation of leaded component 140, the mounting position of leaded component 140, and the required mounting accuracy of leaded component 140. In this manner, by setting holding time T₂ (sec), leaded component 140 is held by suction nozzle 66 after molten solder 150 application to leads 144 has been completed until molten solder 150 hardens.

According to the above work, leaded component 140 is mounted on circuit board 12 with component main body 142 held in a state away from circuit board 12, with the mounted leaded component 140 being attached to circuit board 12 via solder. Thus, by applying molten solder to leads 144 inserted into through-holes 148 and to the location on circuit board 12 at which leads 144 are inserted, an electrical connection is completed between leads 144 and circuit board 12, thus forming an electrical circuit.

In this manner, component mounter 10 is provided with component mounting device 24 that performs mounting work, and soldering device 36 that performs soldering work. Thus, it is possible to mount a leaded component 140 on circuit board 12 and to solder the leaded component 140 to the circuit board 12 in a single component mounter 10. Also, by applying molten solder to leaded component 140 being held by suction nozzle 66 and holding leaded component 140 for which application of molten solder is complete by suction nozzle 66, it is possible to solder leaded component 140 at a planned mounting position with high accuracy.

In contrast, conventionally, mounting work and soldering work are performed respectively by a mounting work machine provided with component mounting device 24 and a soldering machine provided with a soldering device. Therefore, at least two work machines are required to mount the leaded component to circuit board 12 and to solder the mounted leaded component 140 to circuit board 12. Further, when performing soldering work with soldering device 36 in a soldering machine, there is a tendency for leaded component 140 mounted on circuit board 12 to shift due to the flowing molten solder. And, usually, the internal diameter of through-holes 148 into which leads 144 are inserted is larger than the external diameter of leads 144, so there is a tendency for positional deviation to occur of leads 144 in through-holes 148 due to the flowing molten solder. Further, not only when molten solder is flowing, but also after flowing of the molten solder is complete, due to the surface tension that occurs as the molten solder is hardening, there is a tendency for positional deviation of the leaded component 140 or raising up of the leaded component 140 to occur. When such positional deviation of the leaded component 140 or raising up of the leaded component 140 occurs, the mounting accuracy of the leaded component 140 worsens, worsening the quality of circuit board 12. Therefore, with a conventional work machine, it is necessary to curtail positional deviation of leaded component 140 and raising up of leaded component 140, thus, after leaded component 140 has been mounted on circuit board 12, it is necessary to use a jig or the like to fix the leaded component 140 the leads of which have been inserted into through-holes 148. In other words, it is necessary to perform work of fixing leaded component 140 that has been mounted on circuit board 12 during mounting work and soldering work.

However, with component mounter 10, as described above, it is possible to mount leaded component 140 onto circuit board 12 and to solder that leaded component 140 to the circuit board 12. By this, it is possible to reduce the quantity of work machines, reduce costs, and reduce the space required to install work machines. Also, because it is not necessary to convey circuit board 12 between work machines, work time is shorter.

Further, with component mounter 10, molten solder is applied to a leaded component 140 in a state being held by suction nozzle 66. Thus, there is no problem with leaded component 140 raising or with positional deviation of leaded component 140 due to flowing molten solder. Also, even after molten solder has finished being applied to leads 144, leaded component 40 is held continuously for a specified time by suction nozzle 66. Thus, there is no problem with leaded component 140 raising or with positional deviation of leaded component 140 due to hardening of molten solder. Accordingly, it is possible to perform soldering of leaded component 140 to circuit board 12 highly accurately after leaded component 140 has been mounted on circuit board 12 without the need to perform holding work of holding leaded component 140 using a jig or the like.

Also, as shown in fig. 4, controller 152 of control device 38 includes insertion section 160, application section 162, and holding release section 164. Insertion section 160 is for inserting leaded component 140 into through-holes 148. Application section 162 is a functional section for applying molten solder to leads 144 inserted into through-holes 148. Holding release section 164 is a functional section for releasing the holding of leaded component 140 by suction nozzle 66 after holding time T₂ (sec) has elapsed from the completion of application of the molten solder.

In an embodiment above, component mounter 10 is an example of a board work machine. Component mounting device 24 is an example of a holding device. Soldering device 36 is an example of an application device. Control device 38 is an example of a control device. Insertion section 160 is an example of an insertion section. Application 162 is an example of an application section. Holding release section 164 is an example of a holding release section. Further, processing performed by insertion section 160 is an example of inserting processing. Processing performed by application section 162 is an example of applying processing. Processing performed by holding release section 164 is an example of holding releasing processing.

Further, the present invention is not limited to the above example embodiments, and various changed or improved methods of embodiment are possible based on the knowledge of someone skilled in the art. Specifically, for example, in an embodiment above, during soldering work, molten solder is flowed towards leads 144, however, molten solder may be applied to leads 144 using various methods. Specifically, for example, leads 144 may be dipped in molten solder, or a member dipped in molten solder may be contacted against leads 144.

Also, in an embodiment above, leaded component 140 is inserted into circuit board 12 from above and molten solder is applied from below circuit board 12, but leaded component 140 may be inserted into circuit board 12 from below and molten solder may be applied from above circuit board 12 When applying molten solder from above circuit board 12, the molten solder may be dripped onto leads 144.

Further, in an embodiment above, leaded component 140 is mounted on circuit board 12 with component main body section 142 held in a state away from circuit board 12, but leaded component 140 may be mounted on circuit board 12 with component main body section 142 contacting circuit board 12. With a leaded component 140 mounted in this manner too, when the molten solder hardens, because surface tension and the like tends to cause positional deviation of leaded component 140, it is beneficial to continue holding leaded component 140 with suction nozzle 66 after application of molten solder has been completed.

### Reference Signs List

10: component mounter (board work machine);
24: component mounting device (holding device);
36: soldering device (applying device);
38: control device;
160: insertion section;
162: application section;
164: holding release section

## Claims

1. A board work machine (10) comprising:
a holding device (24) configured to hold a leaded component (140) having a lead (144) and insert the lead (144) into a through-hole (148) formed in a board (12);
an applying device (36) configured to apply molten solder to the lead (144) inserted into the through-hole (148); and
a control device (38), the control device (38) being provided with
an insertion section (160) configured to cause the holding device (24) to insert the lead (144) into the through-hole (148);
an application section (162) configured to cause the applying device (36) to apply molten solder to the lead (144) of the leaded component (140) while the leaded component (140) is being held by the holding device (24); and
a holding release section (164) configured to set a setting time for the leaded component (140) to be held by the holding device (24) after the applying device (36) has completed applying molten solder to the lead (144) and to cause the holding device (24) to release the leaded component (140) after the setting time has elapsed,
**characterized in that**
the holding release section (164) is configured to set the setting time in accordance with at least one of a size of the leaded component (140), a shape of the leaded component (140), a thermal capacity of the leaded component (140), a heat dissipation ratio of the leaded component (140), a length of the lead (144), a diameter of the lead (144), an insertion amount of the lead (144) into the through-hole (148), a mounting orientation of the leaded component (140), a mounting position of leaded component (140), and a required mounting accuracy of leaded component (140).

2. The board work machine (10) according to claim 1, wherein
the holding release section (164) is configured to cause the holding device (24) to release the leaded component (140) after the setting time has elapsed following the completion of the applying molten solder by the applying device (36).

3. An insertion method for inserting a leaded component (140) into a board (12) using a board work machine (10) provided with a holding device (24) configured to hold a leaded component (140) having a lead (144) and insert the lead (144) into a through-hole (148) formed in a board (12), and an applying device (36) configured to apply molten solder to the lead (144) inserted into the through-hole (148), the insertion method comprising:
inserting the lead (144) into the through-hole (148) using the holding device (24);
applying molten to the lead (144) of the leaded component (140) using the applying device (36) while the leaded component (140) is being held by the holding device (24);
setting a setting time for the leaded component (140) to be held by the holding device (24) after the applying device (36) has completed applying molten solder to the lead (144); and
releasing the leaded component (140) from holding by the holding device (24) after the setting time has elapsed,
**characterized in that**
the setting time is set by a holding release section (164) of a control device (38) in accordance with at least one of a size of the leaded component (140), a shape of the leaded component (140), a thermal capacity of the leaded component (140), a heat dissipation ratio of the leaded component (140), a length of the lead (144), a diameter of the lead (144), an insertion amount of the lead (144) into the through-hole (148), a mounting orientation of the leaded component (140), a mounting position of leaded component (140), and a required mounting accuracy of leaded component (140).

## Patentansprüche

1. Eine Plattenbearbeitungsmaschine (10) umfassend:
eine Haltevorrichtung (24), die konfiguriert ist ein bedrahtetes Bauteil (140) mit einem Anschluss (144) zu halten und den Anschluss (144) in ein in einer Platte (12) ausgebildetes Durchgangsloch (148) einzuführen;
eine Auftragungsvorrichtung (36), die konfiguriert ist geschmolzenes Lot auf den in das Durchgangsloch (148) eingeführten Anschluss (144) aufzutragen; und
eine Steuervorrichtung (38), wobei die Steuervorrichtung (38) versehen ist mit
einem Einführungsabschnitt (160), der konfiguriert ist die Haltevorrichtung (24) zu veranlassen, den Anschluss (144) in das Durchgangsloch (148) einzuführen;
einen Auftragabschnitt (162), der konfiguriert ist, die Auftragungsvorrichtung (36) zu veranlassen, geschmolzenes Lot auf den Leiter (144) des bedrahteten Bauteils (140) aufzutragen, während das bedrahtete Bauteil (140) von der Haltevorrichtung (24) gehalten wird; und
einen Haltefreigabeabschnitt (164), der konfiguriert ist eine Einstellzeit für das bedrahtete Bauteil (140), das von der Haltevorrichtung (24) gehalten werden soll, einzustellen, nachdem die Auftragungsvorrichtung (36) das Aufbringen von geschmolzenem Lot auf den Anschluss (144) beendet hat, und die Haltevorrichtung (24) zu veranlassen, das bedrahtete Bauteil (140) freizugeben, nachdem die Einstellzeit verstrichen ist,
**gekennzeichnet dadurch, dass**
der Haltefreigabeabschnitt (164) konfiguriert ist die Einstellzeit in Übereinstimmung mit mindestens einer Größe des bedrahteten Bauteils (140), einer Form des bedrahteten Bauteils (140), einer Wärmekapazität des bedrahteten Bauteils (140), einem Wärmeableitungsverhältnis des bedrahteten Bauteils (140) einer Länge des Anschlusses (144), eines Durchmessers des Anschlusses (144), einer Einführmenge des Anschlusses (144) in das Durchgangsloch (148), einer Montageausrichtung des bedrahteten Bauteils (140), einer Montageposition des bedrahteten Bauteils (140) und einer erforderlichen Montagegenauigkeit des bedrahteten Bauteils (140) einzustellen.

2. Die Plattenbearbeitungsmaschine (10) gemäß Anspruch 1, wobei
der Haltefreigabeabschnitt (164) konfiguriert ist die Haltevorrichtung (24) zu veranlassen, das bedrahtete Bauteil (140) freizugeben, nachdem die Einstellzeit nach dem Abschluss des Auftragens von geschmolzenem Lot durch die Auftragungsvorrichtung (36) verstrichen ist.

3. Ein Einsetzverfahren zum Einsetzen eines bedrahteten Bauteils (140) in eine Leiterplatte (12) unter Verwendung einer Plattenbearbeitungsmaschine (10), die mit einer Haltevorrichtung (24), die konfiguriert ist ein bedrahtetes Bauteil (140) mit einem Anschluss (144) zu halten und den Anschluss (144) in ein in einer Leiterplatte (12) ausgebildetes Durchgangsloch (148) einzusetzen, und einer Auftragungsvorrichtung (36) versehen ist, die konfiguriert ist geschmolzenes Lot auf den in das Durchgangsloch (148) eingesetzten Anschluss (144) aufzutragen, wobei das Einsetzverfahren Folgendes umfasst:
Einführen des Anschlusses (144) in das Durchgangsloch (148) unter Verwendung der Haltevorrichtung (24);
Aufbringen von Lot auf den Anschluss (144) des bedrahteten Bauteils (140) unter Verwendung der Auftragungsvorrichtung (36), während das bedrahtete Bauteil (140) von der Haltevorrichtung (24) gehalten wird;
Einstellen einer Einstellzeit für das bedrahtete Bauteil (140), das von der Haltevorrichtung (24) gehalten werden soll, nachdem die Auftragungsvorrichtung (36) das Auftragen von geschmolzenem Lot auf den Anschluss (144) beendet hat; und
Freigeben des bedrahteten Bauteils (140) aus dem Halten durch die Haltevorrichtung (24), nachdem die Einstellzeit verstrichen ist,
**gekennzeichnet dadurch, dass**
die Aushärtezeit durch einen Haltefreigabeabschnitt (164) einer Steuervorrichtung (38) in Übereinstimmung mit mindestens einem von einer Größe des bedrahteten Bauteils (140), einer Form des bedrahteten Bauteils (140), einer Wärmekapazität des bedrahteten Bauteils (140), einem Wärmeableitungsverhältnis des bedrahteten Bauteils (140) einer Länge des Anschlusses (144), eines Durchmessers des Anschlusses (144), einer Einführmenge des Anschlusses (144) in das Durchgangsloch (148), einer Montageausrichtung des bedrahteten Bauteils (140), einer Montageposition des bedrahteten Bauteils (140) und einer erforderlichen Montagegenauigkeit des bedrahteten Bauteils (140) eingestellt wird.

## Revendications

1. Machine de travail sur carte (10) comprenant :
un dispositif de maintien (24) configuré pour maintenir un composant à broches (140) comportant une broche (144) et insérer la broche (144) dans un trou traversant (148) formé dans une carte (12) ;
un dispositif d'application (36) configuré pour appliquer de la brasure fondue sur la broche (144) insérée dans le trou traversant (148) ; et
un dispositif de contrôle (38), le dispositif de contrôle (38) étant pourvu
d'une section d'insertion (160) configurée pour amener le dispositif de maintien (24) à insérer la broche (144) dans le trou traversant (148) ;
d'une section d'application (162) configurée pour amener le dispositif d'application (36) à appliquer de la brasure fondue sur la broche (144) du composant à broches (140) pendant que le composant à broches (140) est maintenu par le dispositif de maintien (24) ; et
d'une section de libération de maintien (164) configurée pour régler un temps de réglage pour que le composant à broches (140) soit maintenu par le dispositif de maintien (24) après que le dispositif d'application (36) a terminé l'application de brasure fondue sur la broche (144) et pour amener le dispositif de maintien (24) à libérer le composant à broches (140) après que le temps de réglage s'est écoulé,
**caractérisée en ce que**
la section de libération de maintien (164) est configurée pour régler le temps de réglage conformément à au moins un paramètre parmi la taille du composant à broches (140), la forme du composant à broches (140), la capacité thermique du composant à broches (140), le ratio de dissipation de chaleur du composant à broches (140), la longueur de la broche (144), le diamètre de la broche (144), la quantité d'insertion de la broche (144) dans le trou traversant (148), l'orientation de montage du composant à broches (140), la position de montage du composant à broches (140), et la précision de montage requise du composant à broches (140).

2. Machine de travail sur carte (10) selon la revendication 1, dans laquelle
la section de libération de maintien (164) est configurée pour amener le dispositif de maintien (24) à libérer le composant à broches (140) après que le temps de prise s'est écoulé suite à l'application de la brasure fondue par le dispositif d'application (36).

3. Procédé d'insertion pour insérer un composant à broches (140) dans une carte (12) à l'aide d'une machine de travail sur carte (10) pourvue d'un dispositif de maintien (24) configuré pour maintenir un composant à broches (140) comportant une broche (144) et pour insérer la broche (144) dans un trou traversant (148) formé dans une carte (12), et d'un dispositif d'application (36) configuré pour appliquer de la brasure fondue sur la broche (144) insérée dans le trou traversant (148), le procédé d'insertion comprenant :
l'insertion de la broche (144) dans le trou traversant (148) à l'aide du dispositif de maintien (24) ;
l'application de matière fondue sur la broche (144) du composant à broches (140) en utilisant le dispositif d'application (36) tandis que le composant à broches (140) est maintenu par le dispositif de maintien (24) ;
le réglage d'un temps de réglage pour que le composant à broches (140) soit maintenu par le dispositif de maintien (24) après que le dispositif d'application (36) a terminé d'appliquer de la brasure fondue sur la broche (144) ; et
la libération du composant à broches (140) du maintien par le dispositif de maintien (24) après que le temps de réglage s'est écoulé,
**caractérisé en ce que**
le temps de réglage est réglé par une section de libération de maintien (164) d'un dispositif de contrôle (38) conformément à au moins un paramètre parmi la taille du composant à broches (140), la forme du composant à broches (140), la capacité thermique du composant à broches (140), le ratio de dissipation de chaleur du composant à broches (140), la longueur de la broche (144), le diamètre de la broche (144), la quantité d'insertion de la broche (144) dans le trou traversant (148), l'orientation de montage du composant à broches (140), la position de montage du composant à broches (140), et la précision de montage requise du composant à broches (140).
